# EUROPEAN PATENT APPLICATION

(11) **EP 1 852 910 A1**
(43) Date of publication of application: **07.11.2007**
(21) Application number: 07100139.0
(22) Date of filing: 04.01.2007
(51) Int. Cl.: H01L 23/498, H05K 3/34

(54) **Mounting substrate and manufacturing method thereof**

(30) Priority: 30.03.2006 JP 2006094711
(71) Applicant: Eudyna Devices Inc., Nakakoma-gun, Yamanashi 409-3883 (JP)
(72) Inventor: Oe, Satoshi, Nakakoma-gun, Yamanashi 409-3883 (JP)
(74) Representative: Hitching, Peter Matthew

(57) **Abstract**

A mounting substrate (10) including an interconnection (12) provided on a front surface of a substrate, a lead pad (24) provided separately from the interconnection (12), on the front surface of the substrate (10) and, a lead (20) connected to the lead pad (24) by solder (22), and a connecting portion (28) that connects the interconnection (12) and the lead pad (24) after the lead (20) is connected.

## Description

### BACKGROUND OF THE INVENTION

### 1. Field of the Invention

This invention generally relates to mounting substrates and manufacturing methods therefor, and more particularly, to a mounting substrate to which leads are fixed by solder and a manufacturing method therefor.

### 2. Description of the Related Art

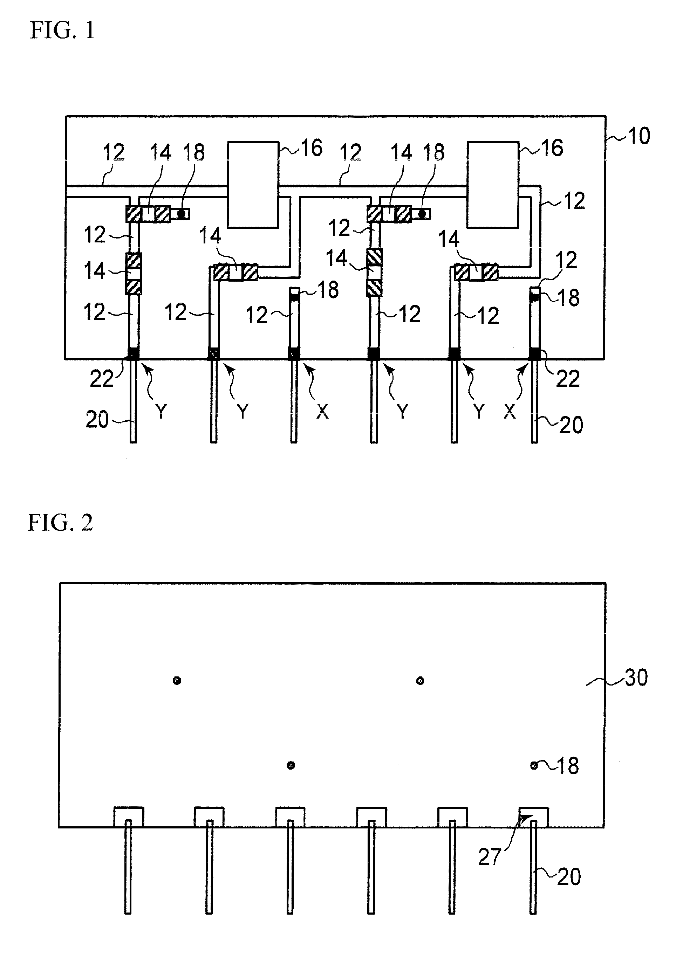

Mounting substrates having electronic components mounted thereon are utilized in various electronic devices. FIG. 1 is a plain view of a surface of a conventional mounting substrate. There are provided interconnections 12 on the surface of an insulating substrate 10. Electronic components such as resistors or capacitors 14 and active elements 16 are coupled to the interconnections 12 by solder. The interconnections 12 are metal films electrically coupling between the electronic components 14 and 16, the leads 20, and a rear surface metal film 30. FIG. 2 is a perspective view of the rear surface of FIG. 1, as viewed from the front surface side. The rear surface metal film 30 is substantially formed on a whole rear surface, with electrically isolated from the leads 20 by isolation portions 27. Some of the interconnections 12 provided on the surface of the substrate 10 shown in FIG. 1 are coupled through vias 18 to the rear surface metal film 30. As shown in FIG. 1 and FIG. 2, the leads 20 are coupled to the interconnections 12 of the substrate 10 by solder. When the mounting substrate is assembled into an electronic apparatus, the leads 20 are soldered to another mounting substrate or the like in the electronic apparatus. This enables electric signals and the power to be input into or output from the interconnections 12 through the leads 20. Solder that includes lead, for example, such as tin-lead (SnPb) solder have conventionally been used, but these years lead-free solder, for example, such as tin-silver-copper (SnAgCu) solder, tin-copper SnCu) solder, tin-antimony (SnSb) solder, or the like is employed in consideration of the influence on the environment.

The electronic components 14 and 16 and the leads 20 are connected to the mounting substrate by soldering the electronic components 14 and 16 to the interconnections 12. Then, the leads 20 are soldered to the interconnections 12. As a method of soldering the leads 20 and the interconnections 12, a dip method is employed, as disclosed, for example, in Japanese Utility Model Application Publication No. 4-131970, by which the connection portions of the leads 20 and those of the interconnections 12 are dipped into molten solder. In the dip method, since the substrate 10 is dipped into the molten solder, soldering is performed at temperatures close to the melting point of the solder so as to suppress the damage caused by thermal expansion of the material of the substrate 10.

When the leads 20 are soldered to the interconnections 12 by use of the dip method, the heat of the solder is dissipated to the rear surface metal film 30 from the interconnections 12 and the temperature of the solder is reduced at solder portions X. This is because the interconnections 12 extended to the solder portions X, to which the leads 20 are attached, are coupled through the vias 18 to the rear surface metal film 30 of the substrate 10. This causes soldering defects at the solder portions X between the leads 20 and the interconnections 12. If the temperature of the molten solder is increased to avoid the aforementioned defects, the soldering defects may be suppressed at the solder portions X. However, the substrate 10 will be damaged at solder portions Y having smaller heat capacities of the interconnections 12. As stated above, the leads 20 cannot be uniformly soldered, when the interconnections 12 have different heat capacities.

In order to solve the problem resulted from the nonuniform temperatures at the time of soldering the leads 20, there may be a method of providing dummy interconnections to the interconnections 12 to make equal the heat capacities of the interconnections 12. However, when the rear surface metal film 30 has a very high heat capacity as in the conventional example shown in FIG. 1 and FIG. 2, the nonuniformity in the heat capacities of the interconnections 12 cannot be eliminated by only adding the dummy interconnections. There may be another method of extending the lengths of the interconnections from the leads 20 to the rear surface metal film 30 to suppress the heat transfer from the leads 20 to the rear surface metal film 30, for the purpose of uniformly soldering the leads 20. However, if a high-frequency module is mounted and the lengths of the interconnections are extended from the leads 20 to the rear surface metal film 30, the electrical characteristic will be changed.

### SUMMARY OF THE INVENTION

The present invention has been made in view of the above circumstances and provides a mounting substrate and a manufacturing method thereof, by which leads can be uniformly soldered at the time of soldering the leads to interconnections of different heat capacitances.

According to one aspect of the present invention, there is provided a mounting substrate including: an interconnection provided on a front surface of a substrate; a lead pad provided separately from the interconnection, on the front surface of the substrate and; a lead connected to the lead pad by solder; and a connecting portion that connects the interconnection and the lead pad after the lead is connected.

According to another aspect of the present invention, there is provided a manufacturing method of a mounting substrate including: connecting a lead by use of solder to a lead pad provided separately from an interconnection provided on a front surface of a substrate; and forming a connecting portion that connects the lead pad and the interconnection.

It is therefore possible to provide a mounting substrate and a manufacturing method thereof, by which the leads can be uniformly soldered at the time of soldering the leads to the interconnections of different heat capacitances.

### BRIEF DESCRIPTION OF THE DRAWINGS

Preferred exemplary embodiments of the present invention will be described in detail with reference to the following drawings, wherein:
FIG. 1 is a plain view of a surface of a conventional mounting substrate;
FIG. 2 is a perspective view of the rear surface of the conventional mounting substrate, as viewed from the front surface side;
FIG. 3A and FIG. 3B are first plain views illustrating a manufacturing method of a mounting substrate in accordance with a first exemplary embodiment of the present invention;
FIG. 4A and FIG. 4B are second plain views illustrating the manufacturing method of the mounting substrate in accordance with the first exemplary embodiment of the present invention;
FIG. 5A through FIG. 5D are cross-sectional views, taken along the line A-A in FIG. 4B, illustrating the manufacturing method of the mounting substrate in accordance with the first exemplary embodiment of the present invention;
FIG. 6 is a cross-sectional view taken along the line B-B in FIG. 4B in accordance with the first exemplary embodiment of the present invention; and
FIG, 7A and FIG. 7B show a manufacturing method of the mounting substrate in accordance with a second exemplary embodiment of the present invention.

### DESCRIPTION OF THE PREFERRED EMBODIMENTS

A description will now be given, with reference to the accompanying drawings, of exemplary embodiments of the present invention.

### (First Exemplary Embodiment)

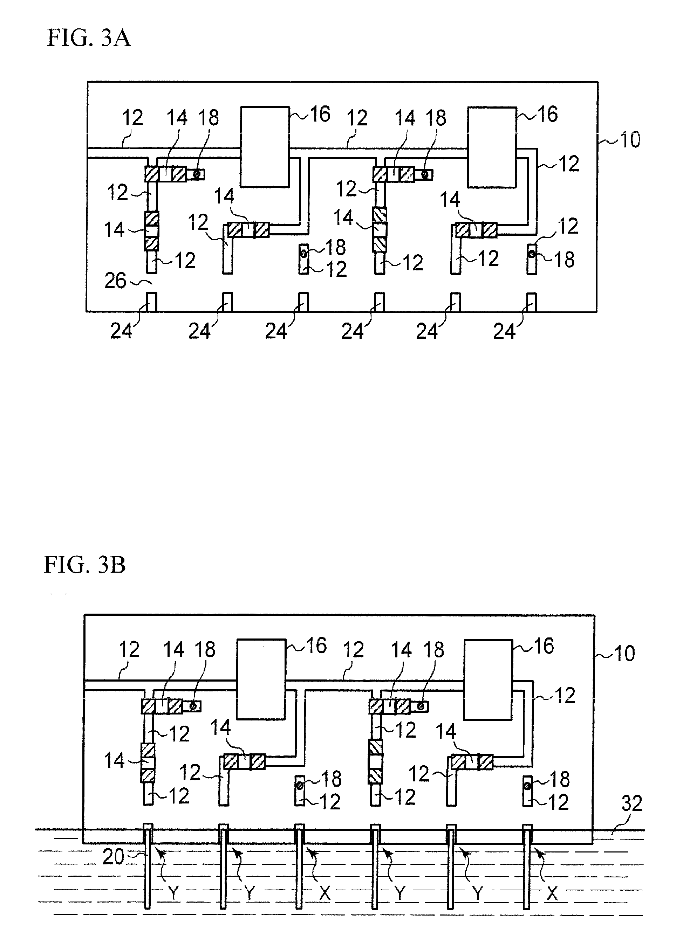

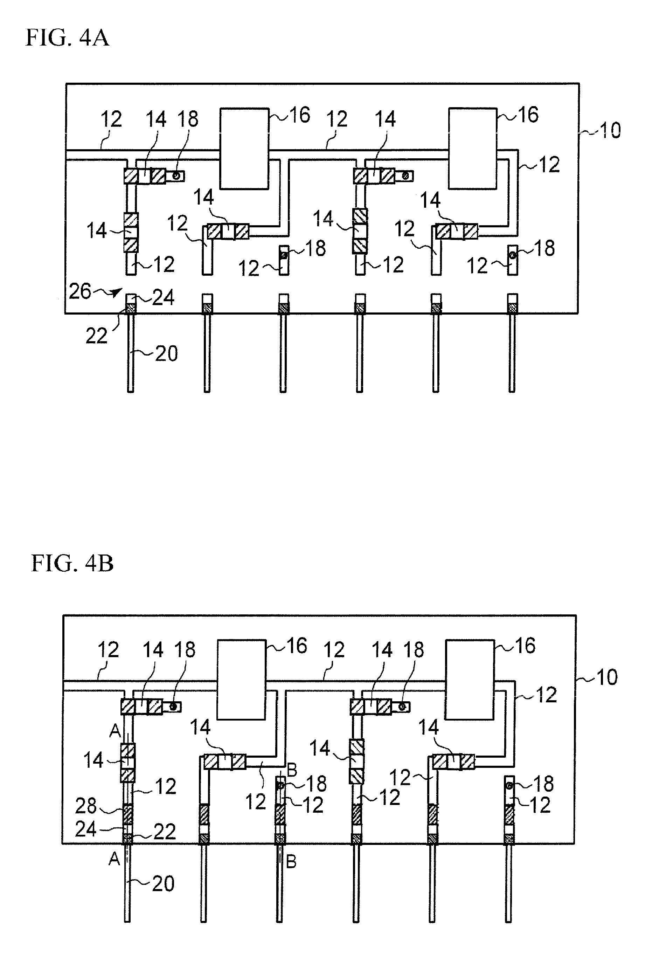

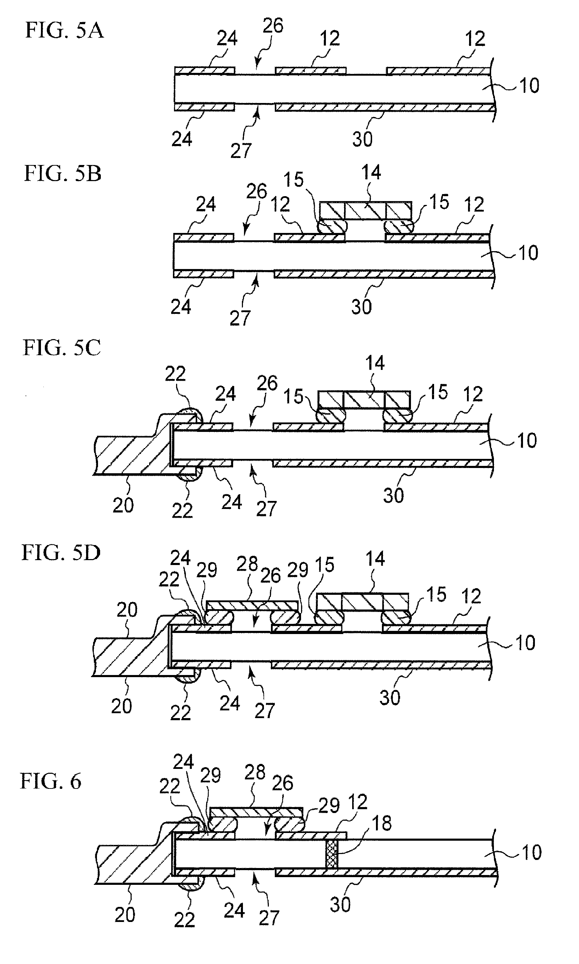

A description will be given, with reference to FIG. 3A through FIG. 6, of a manufacturing method of a mounting substrate employed in the first exemplary embodiment. The first exemplary embodiment is an example of a mounting substrate of a power amplifier module for use in a base station for mobile telephones. FIG. 3A through FIG. 4B are plain views of the mounting substrate. FIG. 5A through FIG. 5D are cross-sectional views take along the line A-A in FIG. 4B. FIG. 6 is a cross-sectional view taken along the line B-B in FIG. 4B. Referring now to FIG. 3A and FIG. 5A, interconnections 12 are provided on the front surface of an insulating substrate 10 made of, for example, polyphenylene oxide (PPO). Some of the interconnections 12 are coupled through vias 18 to a rear surface metal film 30 formed on the rear surface, which is the other surface opposite to the surface having electronic components mounted thereon, of the substrate 10. The rear surface of the substrate 10 has the same configurations as those of the conventional example shown in FIG. 2, and a detailed explanation will be omitted. There are provided lead pads 24 that connect the leads 20, on the front surface and on the rear surface of the substrate 10, at one side of the substrate 10. The interconnections 12, the lead pads 24, and the rear surface metal film 30 are formed of metal films made of, for example, copper plated with gold. The lead pads 24 provided on the front surface of the substrate 10 are provided separately from the interconnections 12 by isolation portions 26. Likewise, the lead pads 24 provided on the rear surface of the substrate 10 are provided separately from the interconnections 12 by isolation portions 27. Since there are no metal films such as the interconnections 12, the lead pads 24, or the rear surface metal films 30 provided in the isolation portions 26 and 27, the isolation portions 26 and 27 are portions of low heat conductance. Referring to FIG. 3A and FIG. 5B, electronic components 14 and 16 are mounted on the interconnections 12 by use of, for example, SnAgCu solder 15.

Referring now to FIG. 3B, the leads 20 are arranged at the lead pads 24, the leads 20 being made of, for example, an alloy having iron as a main component and being plated with Sn. The leads 20 and the lead pads 24 are dipped in SnCu solder 32 melted at approximately 270 °C. The lead pads 24 and the interconnections 12 are provided separately, thereby suppressing the heat of the SnCu solder 32 from transferring and dissipating through the interconnections 12. Referring now to FIG. 4A and FIG. 5C, the leads 20 are connected and bonded to the lead pads 24 by solder 22. Referring now to FIG. 4B and FIG. 5D, the lead pads 24 and the interconnections 12, which are provided separately, are connected by use of a conductive connecting portion 28 made of, for example, a copper plate plated with gold. The connecting portions 28 are connected through, for example, SnAgCu solder 29, to the lead pads 24 and the interconnections 12. FIG. 6 is a cross-sectional view taken along the line B-B shown in FIG. 4B. The interconnections 12, which are coupled through the vias 18 to the rear surface metal film, are also coupled through the connecting portion 28 to the lead pads 24.

In the manufacturing method of the mounting substrate employed in the first exemplary embodiment, the leads 20 are connected by solder to the lead pads 24, which are provided separately from the interconnections 12 provided on the front surface of the substrate 10, as shown in FIG. 3B. Then, the connecting portions 28 are formed to connect the lead pads 24 and the interconnections 12, subsequent to the connection of the leads 20. In the mounting substrate employed in the first exemplary embodiment, the interconnections 12 and the lead pads 24 are provided separately, and are connected by the connecting portions 28. When the mounting substrate is manufactured in this manner, the interconnections 12 and the lead pads 24 are provided separately at the time of connecting the leads 20 to the lead pads 24, as shown in FIG. 3B. Accordingly, even if the interconnections 12 have a large heat capacity, heat will not transfer or dissipate through the interconnections 12. It is therefore possible to suppress the decrease of the temperatures at solder portions X and solder portions Y, where the leads 20 and the lead pads 24 are connected. This makes it possible to uniformly solder the leads, when the leads are soldered to the interconnections having different heat capacities.

In particular, in the solder portions X, the interconnections 12 coupled to the rear surface metal film 30 have very large heat capacitances, and the temperature of the solder is rapidly decreased. For this reason, the interconnections 12 coupled to the rear surface metal film 30 are provided separately from the lead pads 24, and the interconnections 12 and the lead pads 24 are connected by the connecting portions 28. This makes it possible to uniformly solder the leads 20.

When the mounting substrate, for example, high-frequency module is used with microwaves, microstriplines are formed of the interconnections 12 provided on the front surface of the substrate 10 and the rear surface metal film 30 provided on the rear surface of the substrate 10. In such case, the rear surface metal film 30 is substantially provided on the whole surface of the rear surface of the substrate 10. It is therefore effective to solder the leads 20 with the lead pads 24 provided separately from the interconnections 12. In many cases, the interconnections 12 serving as ground have a large heat capacitance. This is because it is effective to isolate the interconnections 12 serving as ground from the lead pads 24 and then to connect the interconnections 12 and the lead pads 24 by means of the connecting portions 28. This eliminates the necessity of extending the lengths of the interconnections from the leads 20 to the rear surface metal film 30 so as to suppress the heat transfer from the leads 20 to the rear surface metal film 30. Therefore, it is possible to uniformly solder the leads 20 without changing the electric characteristics of the high-frequency module.

In the first exemplary embodiment, all the lead pads 24 are provided to be provided separately from the corresponding interconnections 12 and all the lead pads 24 are respectively connected through the connecting portions 28 to the corresponding interconnections 12. This enables the leads 20 to be connected to the lead pads 24 regardless of the heat capacitances of the interconnections 12. It is therefore possible to solder the leads 20 more uniformly.

The leads 20 are connected to the lead pads 24 by dipping the leads 20 and lead pads 24 in the molten solder 32, as shown in FIG. 3B. When the dip method is employed for the manufacturing of the conventional mounting substrate, the temperature of the molten solder 32 is rapidly decreased at the time of coupling the leads 20 to the interconnections 12 with high heat capacitances. Therefore, it is effective to employ the dip method for the manufacturing of the conventional mounting substrate, as in the first exemplary embodiment.

### (Second Exemplary Embodiment)

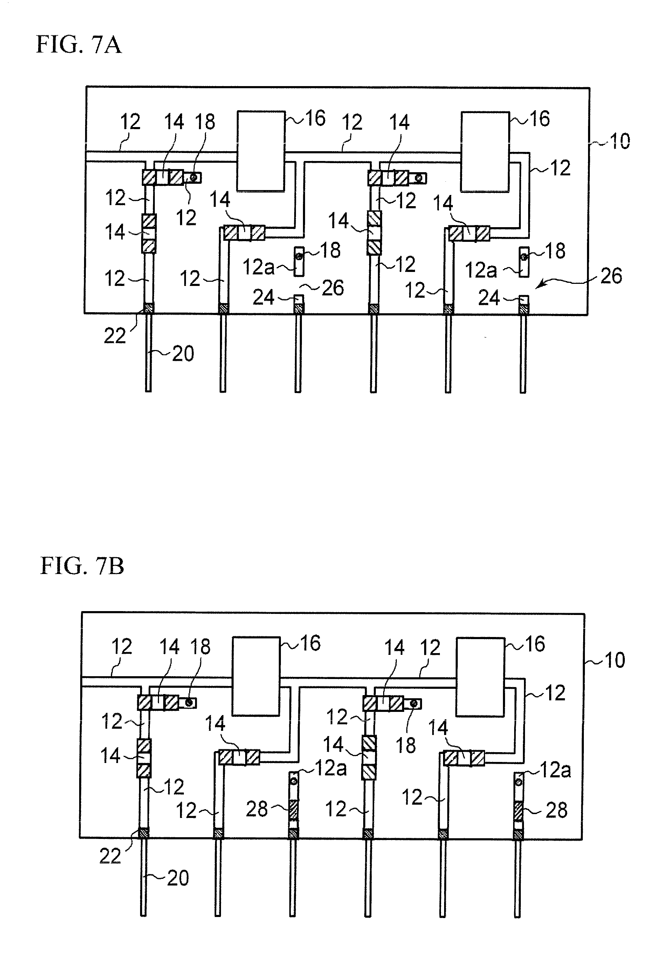

FIG. 7A and FIG. 7B show a manufacturing method of the mounting substrate in accordance with a second exemplary embodiment of the present invention. FIG. 7A corresponds to FIG. 4A used in the first exemplary embodiment. Referring now to FIG. 7A, interconnections 12a to be coupled to the rear surface metal film 30 are provided separately from the lead pads 24, and there are provided the isolation portions 26. Other interconnections 12 are integrally formed with the lead pads 24. In the second exemplary embodiment, the same components and configurations as those shown in FIG. 3C have the same reference numerals and a detailed explanation will be omitted. FIG. 7B corresponds to FIG. 4B. Referring to FIG. 7A, the connecting portions 28 are formed to connect the interconnections 12a coupled to the rear surface metal film 30, and the lead pads 24.

In the second exemplary embodiment, there are provided the isolation portions 26 only between the lead pads 24 and the interconnections 12a having large heat capacitances, as shown in FIG. 7A. Soldering defects easily occur, in particular, at the leads 20 coupled to the interconnections 12a of large heat capacitances. It is therefore possible to uniformly solder the leads 20 also in the second exemplary embodiment. In addition, as shown in FIG. 7B, it is possible to reduce the number of the portions where the connecting portions 28 are formed. This enables the manufacturing costs to be reduced. The second exemplary embodiment is an example in which the interconnections 12a coupled to the rear surface metal film 30 are provided separately from the lead pads 24, the rear surface metal film 30 being substantially provided on the whole rear surface. However, the rear surface metal film 30, if having a large heat capacitance, may not be necessarily provided on the whole rear surface of the substrate 10. In addition, the interconnections 12a provided separately from the lead pads 24 may have large heat capacitances on the front surface of the substrate 10.

In many cases, the mounting substrates employed in the first and second exemplary embodiments are mounted on another mounting substrate of an electronic device, by use of SnAgCu solder. In order to prevent the leads 20 from dropping off during the aforementioned mounting process, it is preferable to use solder having a higher melting point than 217 °C, which is a melting point of SnAgCu solder. However, if the melting point of the solder 22 is high, the substrate 10 will be damaged. Therefore, it is preferable to employ SnCu solder having a melting point of 227 °C, which is a little higher than that of the SnAgCu solder. As the solder having a similar melting point, for example, SnSb solder may be used. If the solder having a higher melting point than that of the SnAgCu solder is employed as described above, the temperature is decreased by the heat dissipating through the interconnections 12 by a great amount. It is therefore effective to employ the manufacturing methods employed in the first and second exemplary embodiments.

Finally, various aspects of the present invention are summarized in the following.

According to an aspect of the present invention, there is provided a mounting substrate including: an interconnection provided on a front surface of a substrate; a lead pad provided separately from the interconnection, on the front surface of the substrate and; a lead connected to the lead pad by solder; and a connecting portion that connects the interconnection and the lead pad after the lead is connected.

The above-described mounting substrate may further include a rear surface metal film provided on the other surface opposite to the front surface of the substrate, and the interconnection may be coupled to the rear surface metal film. It is also possible to uniformly solder the leads at the time of soldering the leads to the corresponding interconnections coupled to the rear surface metal film of a large heat capacitance.

In the above-described mounting substrate, the interconnection may serve as ground. It is also possible to uniformly solder the leads at the time of soldering the leads that correspond to the interconnections, of large heat capacitance, used for ground.

In the above-described mounting substrate, all lead pads may be provided separately from corresponding interconnections, and may be connected through connecting portions to the corresponding interconnections. It is possible to solder the leads more uniformly,

According to another aspect of the present invention, there is provided a manufacturing method of a mounting substrate including: connecting a lead by use of solder to a lead pad provided separately from an interconnection provided on a front surface of a substrate; and forming a connecting portion that connects the lead pad and the interconnection.

In the above-described mounting method, connecting the lead by use of solder to the lead pad may include connecting the lead to the lead pad by dipping the lead pad and the lead in molten solder. It is possible to uniformly solder the leads, at the time of soldering the leads by use of a dip method, which may result in the nonuniformity in soldering.

The above-described mounting method may further include a rear surface metal film provided on the other surface opposite to the front surface of the substrate, and the interconnection may be coupled to the rear surface metal film. It is also possible to uniformly solder the leads, at the time of soldering the leads corresponding to the interconnections coupled to the rear surface metal film of a large heat capacitance.

In the above-described mounting method, the interconnection may serve as ground. It is also possible to uniformly solder the leads at the time of soldering the leads that correspond to the interconnections, of large heat capacitance, used for ground.

In the above-described mounting method, all lead pads may be provided separately from corresponding interconnections; and forming connecting portions may include forming the connecting portions that respectively connect all the lead pads to the corresponding interconnections. It is possible to solder the leads more uniformly.

Although a few specific exemplary embodiments employed in the present invention have been shown and described, it would be appreciated by those skilled in the art that changes may be made in these exemplary embodiments without departing from the principles and spirit of the invention, the scope of which is defined in the claims and their equivalents.

The present invention is based on Japanese Patent Application No. 2006-094711 filed on March 30, 2006, the entire disclosure of which is hereby incorporated by reference.

## Claims

1. A mounting substrate comprising:
an interconnection provided on a front surface of a substrate;
a lead pad provided separately from the interconnection, on the front surface of the substrate and;
a lead connected to the lead pad by solder; and
a connecting portion that connects the interconnection and the lead pad after the lead is connected.

2. The mounting substrate as claimed in claim 1, further comprising a rear surface metal film provided on the other surface opposite to the front surface of the substrate,
wherein the interconnection is coupled to the rear surface metal film.

3. The mounting substrate as claimed in claim 1, wherein the interconnection serves as ground.

4. The mounting substrate as claimed in claim 1, wherein all lead pads are provided separately from corresponding interconnections, and is connected through connecting portions to the corresponding interconnections.

5. A manufacturing method of a mounting substrate comprising:
connecting a lead by use of solder to a lead pad provided separately from an interconnection provided on a front surface of a substrate; and
forming a connecting portion that connects the lead pad and the interconnection.

6. The manufacturing method as claimed in claim 5, wherein connecting the lead by use of solder to the lead pad includes connecting the lead to the lead pad by dipping the lead pad and the lead in molten Solder.

7. The manufacturing method as claimed in claim 5, further comprising a rear surface metal film provided on the other surface opposite to the front surface of the substrate,
wherein the interconnection is coupled to the rear surface metal film.

8. The manufacturing method as claimed in claim 5, wherein the interconnection serves as ground.

9. The manufacturing method as claimed in claim 5, wherein:
all lead pads are provided separately from corresponding interconnections; and
forming connecting portions includes forming the connecting portions that respectively connect all the lead pads to the corresponding interconnections.
